# EUROPÄISCHE PATENTSCHRIFT

(11) **EP 2 851 909 B1**
(45) Veröffentlichungstag und Bekanntmachung des Hinweises auf die Patenterteilung: **02.08.2017**
(21) Anmeldenummer: 13184970.5
(22) Anmeldetag: 18.09.2013
(51) Int. Cl.: H01B 9/00, H02P 29/00, H02P 3/00, H02P 4/00, H02P 15/00, H02K 7/10, H04B 3/00, H05K 7/14

(54) **Antriebssystem mit kombinierter Ansteuerung von Bremse und Geber**
Drive system with combined control of the brake and transducer
Système d'entraînement avec commande combinée du frein et du capteur

(43) Veröffentlichungstag der Anmeldung: 25.03.2015
(73) Patentinhaber: Siemens Aktiengesellschaft, 80333 München (DE)
(72) Erfinder: Kuhn, Andreas, 09123 Chemnitz (DE)

(56) Entgegenhaltungen:
- DE-A1- 10 357 806
- DE-A1- 19 908 045
- DE-A1-102011 100 361
- US-A1- 2004 239 185

## Beschreibung

Die vorliegende Erfindung betrifft ein Antriebssystem insbesondere für eine Produktionsmaschine mit einem Stromrichter, einem Elektromotor, der eine Bremse und einen Geber aufweist sowie einer Leitungsvorrichtung, die den Stromrichter mit dem Elektromotor verbindet, die mindestens zwei Leistungsleitungen sowie zwei Bremsleitungen zur Versorgung der Bremse aufweist, und die zur Datenübertragung zwischen Stromrichter und Elektromotor sowie zur Übertragung von Energie zum Geber ausgebildet ist.

Ein derartiges Antriebssystem ist also für eine Produktionsmaschine, z. B. eine Fräsmaschine, eine Drehmaschine und dergleichen geeignet. Es kann aber auch für Roboter, Förderbänder usw. eingesetzt werden. Antriebssysteme hierfür werden auch als Servoantriebe bezeichnet. Sie besitzen typischerweise einen Elektromotor mit Bremse und einen Stromrichter, der über mehrere Kabel mit dem Elektromotor verbunden ist.

In elektrischen Servoantrieben werden zur Erfassung der Position des Motors heute meist Geber bzw. Encoder mit digitaler Schnittstelle im Motor eingesetzt. Diese Encoder werden über eine Encoderleitung angeschlossen, die nach dem Stand der Technik die Spannungsversorgungsleiter und die zur Übertragung der Daten notwendigen Leiter enthält.

Parallel zu den Datenleitungen und den Spannungsversorgungsleitungen für den Encoder sind sogenannten Leistungsleitungen vorzusehen, über die elektrische Energie zum Motor übertragen werden kann. Darüber hinaus sind Ansteuerleitungen für die Bremse vorzusehen, die in der Regel über eine Gleichspannung (z.B. 24 V DC) angesteuert wird. Meist sind die Leitungen zwischen Umrichter und Elektromotor in zwei Kabeln zusammengefasst, die parallel laufen, und die im Kabelkanal und der Schleppkette Platz benötigen. Dies ist nicht immer vorteilhaft.

Auf dem Markt ist aber bereits eine Lösung verfügbar, bei der lediglich ein Kabel zwischen Stromrichter und Elektromotor notwendig ist, wobei der Elektromotor eine Bremse und einen Geber aufweist. Mit der Einführung der Encoderschnittstelle "HiperfaceDSL" der Firma Sick-Stegmann ist es möglich, auf nur zwei verdrillten Leitungen die Spannungsversorgung und die Datenkommunikation zum Encoder bzw. Geber zu realisieren. Eine derartige Leitung kann sehr dünn sein und zusammen mit den Leistungsleitungen in ein einziges Kabel integriert werden. Hiermit muss der Anwender nur noch ein einziges Kabel (allgemein Leitungsvorrichtung), das/die die Encoderleitungen umfasst, zwischen Stromrichter und Motor anschließen. Dadurch vereinfacht sich die Anschlusstechnik. Der Anwender benötigt jedoch einen speziellen Stecker am Motor, der die zusätzlichen Kontakte für die beiden Kommunikationsadern beherbergt. Solche Stecker sind bis Steckergröße 1,5 am Markt verfügbar. Darüber hinaus gibt es jedoch keine entsprechende Anschlusstechnik.

Aus der Druckschrift DE 10 2011 100 361 A1 ist ein Antriebssystem mit einem Elektromotor und einem Umrichter bekannt, die über ein Kabelsystem miteinander verbunden sind. Das Kabelsystem besitzt Starkstromleitungen zur Versorgung des Motors und zwei Versorgungsleitungen zur Versorgung einer Bremse sowie eines Gebers. Daneben werden zwei Schwachstromleitungen zur Datenübertragung von/zu der Bremse und dem Geber genutzt.

Das weitere Dokument US 2004/0239185 A1 beschreibt eine Schaltung mit einer Steuerung, einem Treiber und einem Aktor, der einen Motor aufweist. Der Treiber erzeugt Gleichspannung unterschiedlicher Polarität, um den Motor in verschiedenen Richtungen antreiben zu können. Unabhängig von der Polarität wird eine Versorgungsspannung für einen Schalter aus den Versorgungsleitungen gewonnen.

Die Aufgabe der vorliegenden Erfindung besteht somit darin, ein Antriebssystem bereitzustellen, das eine vereinfachte Anschlusstechnik aufweist.

Erfindungsgemäß wird diese Aufgabe gelöst durch ein Antriebssystem insbesondere für eine Produktionsmaschine mit
- einem Stromrichter,
- einem Elektromotor, der eine Bremse und einen Geber aufweist, und
- einer Leitungsvorrichtung, die den Stromrichter mit dem Elektromotor verbindet, die mindestens zwei Leistungsleitungen sowie zwei Bremsleitungen zur Versorgung der Bremse aufweist, und die zur Datenübertragung zwischen Stromrichter und Elektromotor sowie zur Übertragung von Energie zum Geber ausgebildet ist,
wobei
- die Leitungsvorrichtung zur Übertragung von Energie und Daten neben den Leistungsleitungen ausschließlich die zwei Bremsleitungen aufweist,
- der Stromrichter ausgebildet ist, eine erste Versorgungsspannung erster Polarität und eine zweite Versorgungsspannung mit gegenüber der ersten umgekehrten zweiten Polarität zu der Versorgung der Bremse und des Gebers an die Bremsleitungen anzulegen, und
- der Elektromotor ausgebildet ist, mit der jeweiligen Versorgungsspannung den Geber unabhängig von ihrer Polarität und die Bremse abhängig von ihrer Polarität zu versorgen.

In vorteilhafter Weise ist also der Stromrichter in der Lage, Versorgungsspannungen unterschiedlicher Polarität zur Verfügung zu stellen. Der Elektromotor seinerseits ist dann in der Lage, den Geber bzw. Encoder unabhängig von der Polarität stetig zu versorgen und die Polarität der Versorgungsspannung dazu zu nutzen, die Bremse spezifisch anzusteuern, d.h. die Bremse zu schließen und zu lösen. Mit dieser Technik ist es dann möglich, die Übertragung von Energie und Daten durch die Leistungsleitungen und ausschließlich zwei zusätzliche Bremsleitungen zu realisieren.

Vorzugsweise sind der Stromrichter und der Elektromotor dazu ausgebildet, die Daten über die Bremsleitungen zu übertragen. Prinzipiell besteht zwar auch die Möglichkeit, die Daten über die Leistungsleitungen für den Motor zu übertragen, aber die Übertragung der Daten über die Bremsleitungen hat den Vorteil, dass die Versorgung des Gebers und der Bremse in der Regel mit Gleichspannung erfolgt, von der ohne großen Aufwand hochfrequente Datensignale zu trennen sind. Wechselströme in den Leistungsleitungen würden die Wechselsignale der Datenübertragung eher beeinflussen.

Die Datenübertragung über die Bremsleitungen kann mit einer Frequenz über 10 kHz und insbesondere über 1 MHz liegen. Vorteilhafterweise wird beispielsweise eine Datenübertragung bei 33 MHz gewählt. Dadurch ist ein genügend großer spektraler Abstand zur Gleichspannungsversorgung von Bremse und Geber, aber auch ein hinreichender Abstand zur Versorgungsfrequenz von üblichen Ein- oder Drei-Phasensystemen für die Motorversorgung gewährleistet. Entsprechend können die Daten sicher übertragen bzw. rückgewonnen werden.

Der Stromrichter kann eine schaltbare Brücke aufweisen, mit der aus der Gleichspannung die erste und zweite Versorgungsspannung erzeugbar ist. Mit einer solchen schaltbaren Brücke kann auf einfache Weise aus einer Gleichspannung eine Versorgungsspannung erster Polarität und umgekehrter zweiter Polarität erzeugt werden.

Günstigerweise ist die Bremse in/an dem Motor über eine Diode an den Bremsleitungen angeschlossen. Auf diese Weise lässt sich die Bremse mit geringem Aufwand polaritätsbezogen ansteuern.

Des Weiteren kann der Geber über einen Brückengleichrichter an die Bremsleitungen angeschlossen sein. Ein derartiger Brückengleichrichter gewährleistet am Ausgang eine Versorgung unabhängig von der Polarität am Eingang.

Zudem können die Bremsleitungen gegenüber den Leistungsleitungen separat geschirmt sein. Hierdurch lässt sich sicherstellen, dass die Datenübertragung durch die Bremsleitungen ungestört erfolgen kann.

Des Weiteren kann eine Gesamtschirmung sämtlicher Leitungen in der Leitungsvorrichtung vorgesehen sein. Dies hat den Vorteil, dass weder in die Leistungsleitungen und die Bremsleitungen von außen Störungen eingekoppelt noch von ihnen nach außen Störungen abgestrahlt werden.

Der Elektromotor kann ein Dreiphasenmotor sein, wobei die Leitungsvorrichtung vier Leistungsleitungen aufweist. Damit können auch übliche Drehstrommotoren mit Bremse und Geber von dem einfachen Anschlussprinzip profitieren.

Optional ist zur Datenübertragung jeweils ein Treiberbaustein sowohl im Stromrichter als auch im Elektromotor an die Bremsleitungen gekoppelt. Handelt es sich bei dem Treiberbaustein beispielsweise um einen Ethernet-Tranceiver, so kann zwischen Stromrichter und Motor eine klassische Ethernet-Kommunikation stattfinden.

Die vorliegende Erfindung wird nun anhand der beigefügten Zeichnungen näher erläutert, in denen zeigen:
- FIG 1: den prinzipiellen Aufbau eines Antriebssystems gemäß der vorliegenden Erfindung; und
- FIG 2: ein Blockschaltbild des Antriebssystems von FIG 1.

Die nachfolgend näher geschilderten Ausführungsbeispiele stellen bevorzugte Ausführungsformen der vorliegenden Erfindung dar.

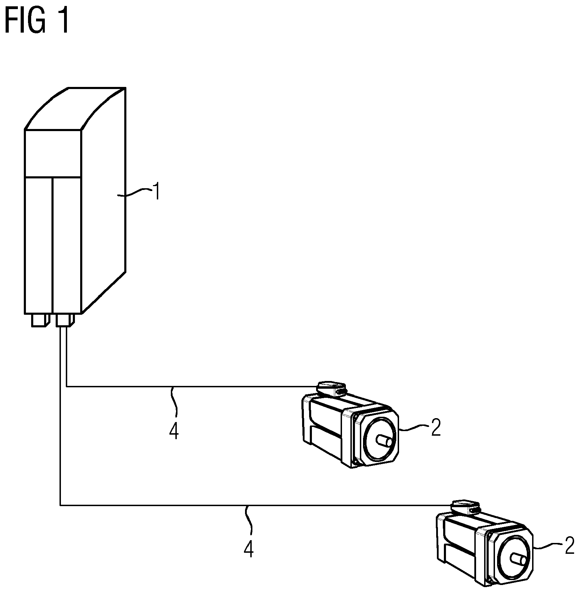

FIG 1 zeigt symbolisch ein Beispiel eines erfindungsgemäßen Antriebssystems, das beispielsweise für eine Fräsmaschine als Antrieb geeignet ist. Das Antriebsystem besitzt einen Stromrichter 1 und hier zwei Elektromotoren 2. Der Stromrichter 1 kann also einen Elektromotor 2 oder mehrere Elektromotoren 2 ansteuern.

Jeder der Elektromotoren 2 besitzt eine nicht dargestellte Bremse und einen nicht dargestellten Geber. Von diesen können beide oder nur einer davon in das Gehäuse des Elektromotors integriert sein. Prinzipiell können beide aber auch gehäuseextern am Elektromotor 2 angebracht sein. Die Bremse dient dazu, die Welle bzw. den Rotor des Motors rasch abzubremsen. Typischerweise wird eine solche Bremse elektromagnetisch betrieben. Dabei ist es aus Sicherheitsgründen vorteilhaft, wenn die Bremse im unbestromten Zustand geschlossen ist und sich bei Bestromung löst.

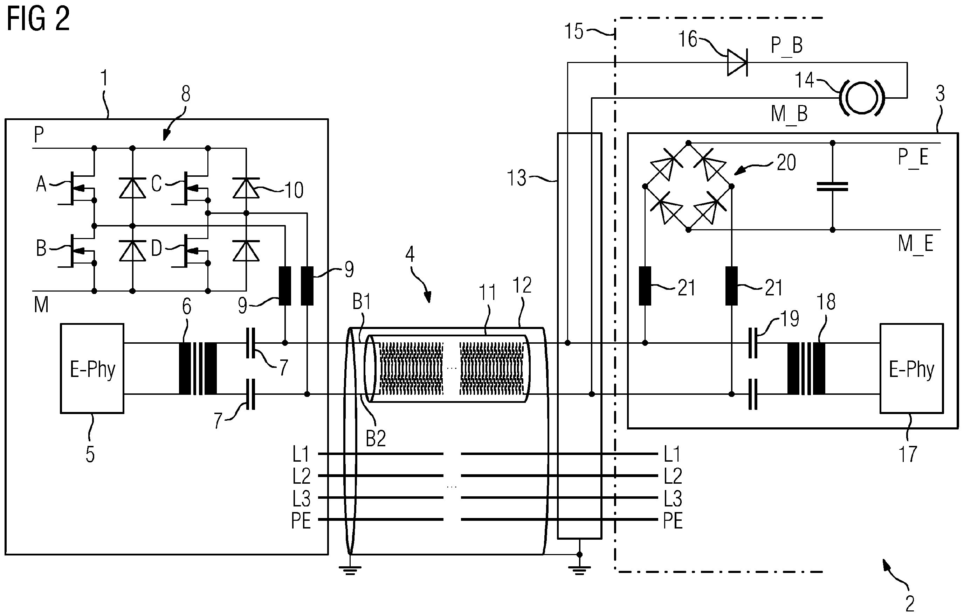

Darüber hinaus weist jeder der beiden Elektromotoren 2 einen Geber bzw. Encoder auf. Mit einem solchen Geber 3 (vgl. FIG 2) ist es möglich, die Drehzahl, den Drehwinkel, die Drehposition oder dergleichen des Rotors bzw. der Welle des Elektromotors 2 zu erfassen und entsprechende Informationen nach außen bereitzustellen.

Jeder der Elektromotoren 2 ist mit einem einzigen Kabel 4 (allg. Leitungsvorrichtung) an den Stromrichter 1 angeschlossen. Ein solches Kabel 4 überträgt
a) die Antriebsenergie für den Elektromotor 2,
b) die Energie für die Versorgung der Bremse,
c) die Energie für die Versorgung des Gebers 3 und
d) Daten zwischen dem Stromrichter 1 und dem Geber 3.

Mit einem einzigen Kabel ist es also gewährleistet, dass zwischen dem Stromrichter 1 und dem Elektromotor 2 einschließlich der integrierten oder angeschlossenen Bremse und Geber die jeweils notwendige Energie und die anfallenden Daten übertragen werden.

In FIG 2 ist ein Blockschaltbild eines mit Hilfe eines Kabels 4 an den Umrichter 1 angeschlossenen Elektromotors 2 dargestellt. Der Stromrichter 1 ist durch ein Rechteck symbolisiert, das praktisch sein Gehäuse repräsentiert. Die Leistungselektronik, die den Dreiphasenstrom für den Antrieb des Elektromotors 2 erzeugt, ist hier der Übersicht halber nicht dargestellt. Stellvertretend für den Leistungsausgang sind lediglich die drei Phasenleiter L1, L2 und L3 sowie der Nullleiter PE (nachfolgend auch als "Leistungsleitungen" bezeichnet) am Ausgang des Stromrichters 1 eingezeichnet. Der Einfachheit halber sind diese Phasen- und Nullleiter durchgehend vom Stromrichter 1 durch das Kabel 4 hindurch zum Elektromotor 2 eingezeichnet. Jede dieser Leistungsleitungen L1, L2, L3 und PE besitzt im oder am Stromrichter einen entsprechenden Anschluss in Form einer Klemme oder eines Buchsen- bzw. Steckerpols.

Der Stromrichter 1 besitzt ferner einen Treiberbaustein 5 als Tranceiver zur Kommunikation mit dem Geber 3. Abstrakt handelt es sich dabei um die physikalische Schicht beispielsweise einer Ethernet-Verbindung. Zwei Kommunikationsleitungen des Treiberbausteins 5 sind an die Primärseite eines zur galvanischen Entkopplung vorgesehenen Transformators 6 im Stromrichter 1 angeschlossen. Sekundärseitig sind die Kommunikationsleitungen über Kondensatoren 7 zu den Bremsleitungen B1 und B2 des Kabels 4 geführt. Dies kann beispielsweise über ein nicht dargestelltes Steckersystem erfolgen.

Darüber hinaus besitzt der Stromrichter 1 eine schaltbare Brücke 8, die eingangsseitig von einer Gleichspannung, symbolisiert durch den Pluspol P und den Minuspol M, gespeist wird. Diese Gleichspannung dient zur Versorgung des motorseitigen Gebers und der motorseitigen Bremse. Die Ausgänge der Brücke 8 sind über Längsinduktivitäten 9 an die Bremsleitungen B1 und B2 angeschlossen. Die Brücke 8 ist als Vollbrücke ausgestaltet und besitzt vier Zweige, in denen jeweils ein Schalter bzw. Transistor, IGBT oder dergleichen A, B, C und D angeordnet ist. Parallel zu jedem dieser Schalter ist eine Diode 10 geschaltet.

Das Kabel 4 ist beispielsweise über einen nicht dargestellten Stecker an den Stromrichter 1 angeschlossen. Neben den Leistungsleitungen L1, L2, L3 und PE befinden sich in dem Kabel 4 als Leitungen nur noch die Bremsleitungen B1 und B2. Die Bremsleitungen B1 und B2 sind von einer separaten Schirmung 11 im Kabel 4 umgeben. Damit sind sie gegenüber den Leistungsleitungen elektromagnetisch abgeschirmt. Zusätzlich besitzt hier das Kabel 4 eine Gesamtschirmung 12, die sämtliche Leitungen des Kabels 4 umgibt. Damit ist das gesamte Kabel 4 elektromagnetisch abgeschirmt. Die Schirmungen 11 und 12 sind lediglich optional vorhanden.

Falls lediglich ein einphasiger Elektromotor über das Kabel 4 anzusteuern bzw. zu versorgen ist, müssen lediglich zwei Leistungsleitungen vorgesehen sein. In diesem Fall wäre das Kabel 4 vieradrig (zwei Leistungsleitungen und zwei Bremsleitungen). Für jede weitere Phase ist eine zusätzliche Leistungsleitung vorzusehen.

Zur Versorgung des dreiphasigen Elektromotors 2 mündet das sechsadrige Kabel 4 motorseitig in einen entsprechenden sechspoligen Stecker 13. Dieser leitet die Leitungen des Kabels 4 ins Motorinnere weiter, sofern die Bremse 14 und der Geber 3 innerhalb des Gehäuses des Elektromotors 2 angeordnet sind. Sofern diese außerhalb des Motorgehäuses angeordnet sind, können die Bremsleitungen B1 und B2 auch außerhalb des Motorgehäuses weitergeleitet werden. In dem Beispiel von FIG 2 ist ein Teil des Motorgehäuses 15 durch eine gestrichelte Linie angedeutet. Wicklungen, in die die Leistungsleitungen L1, L2 und L3 bzw. PE münden, sind der Übersicht halber nicht dargestellt.

In dem Beispiel von FIG 2 befinden sich der Geber 3 und die Bremse 14 innerhalb des Motorgehäuses 15. Die Bremse 14, mit der der Rotor des Elektromotors 2 bzw. seine Welle gebremst werden kann, ist über eine Diode 16 an die beiden Bremsleitungen B1 und B2 angeschlossen. Es ist also durch die Bremse 14 nur Stromfluss in eine Richtung möglich. Für die Ansteuerung der Bremse ergibt sich somit ein Pluspol P_B und ein Minuspol M_B.

Der Encoder bzw. Geber 3 ist ebenfalls an die Bremsleitungen B1 und B2 angeschlossen. Er besitzt ebenfalls einen Treiberbaustein 17 als Tranceiver für die Kommunikation mit dem Stromrichter 1. Der Treiberbaustein 17 ist aus seiner Sicht primärseitig ebenfalls an einen Transformator 18 zur galvanischen Entkopplung angeschlossen. An dessen Sekundärseite sind die Bremsleitungen B1 und B2 über Kondensatoren 19 angeschlossen.

Die Stromversorgung des Gebers 3 erfolgt über die Bremsleitungen B1 und B2. Dazu ist der Eingang einer Vollbrücke 20 über Längsinduktivitäten 21 mit den Bremsleitungen B1 und B2 verbunden. Am Ausgang der Vollbrücke 20 ergibt sich ein Pluspol P_E und ein Minuspol M_E für die Spannungsversorgung des Encoders bzw. Gebers 3. Beide Pole sind zur Gleichspannungsglättung optional mit einem Kondensator 22 verbunden.

Im Folgenden sei der Betrieb des Antriebssystems näher erläutert. Dabei sind drei Betriebszustände wesentlich:
I) der Elektromotor ist abgeschaltet und die Bremse ist geschlossen,
II) der Elektromotor läuft und die Bremse ist gelüftet und
III) der Elektromotor läuft (zumindest vorübergehend) und die Bremse ist geschlossen.

Während des Zustands I), bei dem der Elektromotor abgeschaltet und die Bremse 14 ebenfalls nicht bestromt ist, ist Letztere mechanisch geschlossen, sodass der Rotor des Elektromotors 2 stillsteht. Die Schalter A, B, C und D der Brücke 8 des Stromrichters 1 sind in diesem Fall nicht bestromt, d.h A = B = C = D = 0. Folglich liegt an den Polen P_B und M_B keine Spannung an und die Bremse ist geschlossen.

Im Zustand II), wenn der Motor läuft, ist die Bremse 14 gelüftet. Dazu werden die Schalter A und D bestromt, nicht hingegen die Schalter B und C, d.h. A = D = 1 und B = C = 0. Dementsprechend wird das positive Potenzial P über den Schalter A an die in FIG 2 obere Bremsleitung B1 gelegt, während das negative Potenzial M über den Schalter D an die untere Bremsleitung B2 gelegt wird. Folglich fließt Strom über die Diode 16 und den Pluspol P_B zur Bremse 14 und von dort über den Minuspol M_B zurück zur unteren Bremsleitung B2. Die Bremse 14 ist also bestromt und damit gelüftet.

Im Zustand III) soll der Motor gebremst werden. Dazu werden die Schalter B und C auf hohes Potenzial und die Schalter A und D auf niedriges Potenzial gelegt, d.h. A = D = 0 und B = C = 1. Dementsprechend wird das positive Versorgungspotenzial über den Schalter C an die untere Bremsleitung B2 und das negative Versorgungspotenzial über den Schalter D an die obere Bremsleitung B1 gelegt. Die Diode 16 verhindert einen Stromfluss von der positiven unteren Bremsleitung B2 über die Bremse 14 zur negativen oberen Bremsleitung B1. Die Bremse 14 wird also nicht bestromt und zieht daher mechanisch an.

Während des gesamten Betriebs ist der Geber 3 über die Bremsleitungen B1 und B2 mit Strom zu versorgen. Im Zustand I) ist der Elektromotor nicht in Betrieb und daher liegt an den Bremsleitungen B1 und B2 keine Spannung an, weswegen auch der Geber 3 nicht mit Strom versorgt wird. Im Zustand II) hingegen, wenn die obere Bremsleitung B1 positiv ist, fließt Strom über die Längsinduktivität 21 zu dem Vollbrückengleichrichter 20. Dort fließt er durch die obere linke Diode zum Pluspol P_E der Encoderversorgung. Zurück fließt der Strom über den Minuspol M_E, die rechte untere Diode und die andere Längsinduktivität 21 in die untere Bremsleitung B2. Der Geber 3 ist also mit Strom versorgt, während der Motor 2 läuft.

Im Zustand III), wenn der Motor abgebremst wird bzw. ist, soll der Geber 3 ebenfalls mit Strom versorgt werden. Dies ist dadurch gewährleistet, dass von der unteren, nun positiven Bremsleitung 2 Strom über die rechte obere Diode des Vollbrückengleichrichters 20 zum Pluspol P_E fließt. Zurück fließt der Strom über den Minuspol M_E und die linke untere Diode des Vollbrückengleichrichters 20 in die jetzt positive obere Bremsleitung B1. Der Stromfluss erfolgt auch hier über die Längsinduktivitäten 21. Die Stromversorgung des Gebers 3 ist also auch in diesem Zustand III) gewährleistet.

Erfindungsgemäß wird auch die Übertragung der Encoderdaten und der Encoderversorgung auf den beiden Adern zur Ansteuern der (DC-)Bremse durchgeführt. Die entsprechenden Verbindungsleiter sind meist schon in der Motorleitung vorhanden und auch die entsprechenden Kontakte sind bereits in den heute üblichen Steckverbindern vorgesehen, so dass hier keine Abweichungen vom Standard erforderlich werden. Zudem reduzieren sich die zu liefernden Varianten der Anschlusstechnik, denn es sind nicht mehr Anschlüsse für Geberleitung und Leistungsleitung mit/ohne Bremsleitung notwendig, sondern nur noch Anschlüsse für Leistungsleitung und Bremsleitung, denn die entsprechenden Kabel können auch für Antriebssysteme ohne Bremse verwendet werden.

In vorteilhafter Weise können also die Funktionen (sichere) Bremsenansteuerung, Geberspannungsversorgung und Kommunikationsschnittstelle über ein einziges Leitungspaar (Bremsleitungen) in einem Kabel realisiert werden. Dabei kann ausgenutzt werden, dass die Ansteuerung der Bremse und die Versorgung des Gebers mit Gleichspannung von z.B. 24 V erfolgt, während die Datenübertragung gleichanteilsfrei beispielsweise bei ca. 33 MHz oder mehr erfolgt. Das entsprechende Wechselsignal liegt spektral soweit von der Gleichspannung entfernt, dass er mit geringem schaltungstechnischen Aufwand von der Gleichspannung getrennt werden kann.

Die Versorgung des Gebers kann so erfolgen, dass er bereits vor, während und nach Lösen der Bremse mit Spannung versorgt ist. Die Bremse hingegen wird sicher bei bestimmten Betriebsfällen geöffnet bzw. wieder geschlossen, was durch die Verpolung der Versorgungsspannung ermöglicht wird.

Der Encoder enthält vorzugsweise einen Brückengleichrichter, der die richtige Polarität der Versorgungsspannung in jedem Fall sicherstellt. Die Bremse jedoch wird günstigerweise mit einer Diode abgekoppelt, die den Stromfluss und damit das Öffnen der Bremse nur bei einer der Polaritäten der Versorgungsspannung ermöglicht. Damit sind, wie oben angedeutet ist, die drei möglichen Betriebsfälle abgedeckt: Geber und Bremse aus/Geber an, Bremse aus/Geber und Bremse an.

In einer vorteilhaften Ausgestaltung ist diese Art der Ansteuerung stromrichterseitig noch mit einer Überwachung kombinierbar, die eine Kontrolle der einzelnen Transistor-Abschaltzweige in der schaltbaren Brücke 8 und damit eine sichere Bremsenansteuerung gemäß diverser Sicherheitsanforderungen ermöglicht.

Bei der digitalen Übertragung wird vorzugsweise ein verdrilltes Adernpaar verwendet. Es können RS485-basierte als auch Sheelded Single Pair Ehternet-basierte Übertragungsprotokolle zum Einsatz kommen. In einer vorteilhaften Anwendungsform wäre es hier also möglich, HiperfaceDSL über die Bremsleitungen zu übertragen.

Bei einer weiteren vorteilhaften Ausführungsform können Echtzeit-Ethernet-Protokolle insbesondere mit Zwei-Wire-Technologie verwendet werden.

## Patentansprüche

1. Antriebssystem, insbesondere für eine Produktionsmaschine, mit
- einem Stromrichter (1),
- einem Elektromotor (2), der eine Bremse (14) und einen Geber (3) aufweist, und
- einer Leitungsvorrichtung (4), die den Stromrichter mit dem Elektromotor verbindet, die mindestens zwei Leistungsleitungen (L1, L2, L4, PE) sowie zwei Bremsleitungen (B1, B2) zur Versorgung der Bremse aufweist, und die zur Datenübertragung zwischen Stromrichter und Elektromotor sowie zur Übertragung von Energie zum Geber ausgebildet ist,
**dadurch gekennzeichnet, dass**
- diese Leitungsvorrichtung (4) zur Übertragung von Energie und Daten neben den Leistungsleitungen ausschließlich die zwei Bremsleitungen aufweist,
- der Stromrichter (1) ausgebildet ist, eine erste Versorgungsspannung erster Polarität und eine zweite Versorgungsspannung mit gegenüber der ersten umgekehrten zweiten Polarität zu der Versorgung der Bremse (14) und des Gebers (3) an die Bremsleitungen anzulegen, und
- der Elektromotor (2) ausgebildet ist, mit der jeweiligen Versorgungsspannung den Geber unabhängig von ihrer Polarität und die Bremse abhängig von ihrer Polarität zu versorgen.

2. Antriebssystem nach Anspruch 1, wobei der Stromrichter (1) und der Elektromotor (2) dazu ausgebildet sind, die Daten über die Bremsleitungen (B1, B2) zu übertragen.

3. Antriebssystem nach Anspruch 2, wobei die Datenübertragung über die Bremsleitungen (B1, B2) mit einer Frequenz über 10 kHz, insbesondere über 1 MHz erfolgt.

4. Antriebssystem nach einem der vorhergehenden Ansprüche, wobei der Stromrichter (1) eine schaltbare Brücke (8) aufweist, mit der aus einer Gleichspannung die erste und die zweite Versorgungsspannung erzeugbar ist.

5. Antriebssystem nach einem der vorhergehenden Ansprüche, wobei die Bremse (14) in/an dem Motor (2) über eine Diode (16) an den Bremsleitungen (B1, B2) angeschlossen ist.

6. Antriebssystem nach einem der vorhergehenden Ansprüche, wobei der Geber (3) über einen Brückengleichrichter (20) an die Bremsleitungen (B1, B2) angeschlossen ist.

7. Antriebssystem nach einem der vorhergehenden Ansprüche, wobei die Bremsleitungen (B1, B2) gegenüber den Leistungsleitungen (L1, L2, L3, PE) separat geschirmt sind.

8. Antriebssystem nach einem der vorhergehenden Ansprüche, wobei eine Gesamtschirmung (12) sämtliche Leitungen in der Leitungsvorrichtung (4) umgibt.

9. Antriebssystem nach einem der vorhergehenden Ansprüche, wobei der Elektromotor (2) ein Dreiphasenmotor ist, und die Leitungsvorrichtung (4) vier Leistungsleitungen (L1, L2, L3, PE) aufweist.

10. Antriebssystem nach einem der vorhergehenden Ansprüche, wobei zur Datenübertragung sowohl im Stromrichter (1) als auch im Elektromotor (2) ein Treiberbaustein (5, 17) an die Bremsleitungen (B1, B2) angekoppelt ist.

## Claims

1. Drive system, in particular for a production machine, having
- a power converter (1),
- an electric motor (2) which has a brake (14) and an encoder (3), and
- a line assembly (4), which connects the power converter to the electric motor, has at least two power lines (L1, L2, L4, PE) and also two brake lines (B1, B2) for supplying the brake, and is designed for data transfer between power converter and electric motor and also for transferring energy to the encoder,
**characterised in that**
- said line assembly (4) for transferring energy and data exclusively has the two brake lines in addition to the power lines,
- the power converter (1) is designed in order to apply a first supply voltage of a first polarity and a second supply voltage having a second polarity opposite to the first to the brake lines for supplying the brake (14) and the encoder (3), and
- the electric motor (2) is designed in order to supply the encoder with the particular supply voltage independently of its polarity and to supply the brake with the particular supply voltage depending on its polarity.

2. Drive system according to claim 1, wherein the power converter (1) and the electric motor (2) are designed in order to transfer the data over the brake lines (B1, B2).

3. Drive system according to claim 2, wherein the data transfer takes place over the brake lines (B1, B2) at a frequency above 10 kHz, in particular above 1 MHz.

4. Drive system according to one of the preceding claims, wherein the power converter (1) has a switchable bridge (8), by means of which the first and second supply voltages can be generated from a DC voltage.

5. Drive system according to one of the preceding claims, wherein the brake (14) is connected to the brake lines (B1, B2) in/on the motor (2) by way of a diode (16).

6. Drive system according to one of the preceding claims, wherein the encoder (3) is connected to the brake lines (B1, B2) by way of a bridge rectifier (20).

7. Drive system according to one of the preceding claims, wherein the brake lines (B1, B2) are shielded separately with respect to the power lines (L1, L2, L3, PE).

8. Drive system according to one of the preceding claims, wherein a total shielding (12) encases all the lines in the line assembly (4).

9. Drive system according to one of the preceding claims, wherein the electric motor (2) is a three-phase motor and the line assembly (4) has four power lines (L1, L2, L3, PE).

10. Drive system according to one of the preceding claims, wherein a driver module (5, 17) is coupled for data transfer purposes to the brake lines (B1, B2) both in the power converter (1) and also in the electric motor (2).

## Revendications

1. Système d'entraînement, notamment pour une machine de production comprenant
- un convertisseur ( 1 ),
- un moteur ( 2 ) électrique, qui a un frein ( 14 ) et un transmetteur ( 3 ) et
- un dispositif ( 4 ) à lignes, qui relie le convertisseur au moteur électrique, qui a au moins deux lignes ( L1, L2, L4, PE ) de puissance, ainsi que deux lignes ( B1, B2 ) de frein pour l'alimentation du frein, et qui est constitué pour la transmission de données entre le convertisseur et le moteur électrique, ainsi que pour le transport d'énergie au transmetteur,
**caractérisé en ce que**
- ce dispositif ( 4 ) à lignes a, pour le transfert d'énergie et la transmission de données, outre les lignes de puissance, exclusivement les deux lignes de frein,
- le convertisseur ( 1 ) est constitué pour appliquer aux lignes de frein, une première tension d'alimentation d'une première polarité et une deuxième tension d'alimentation d'une deuxième polarité, opposée à la première, pour l'alimentation du frein ( 14 ) et du transmetteur ( 3 ) et
- le moteur ( 2 ) électrique est constitué pour appliquer la tension d'alimentation respective au transmetteur, indépendamment de sa polarité, et au frein en fonction de sa polarité.

2. Système d'entraînement suivant la revendication 1, dans lequel le convertisseur ( 1 ) et le moteur ( 2 ) électrique sont constitués pour transmettre les données par l'intermédiaire des lignes ( B1, B2 ) de frein.

3. Système d'entraînement suivant la revendication 2, dans lequel le transfert de données par les lignes ( B1, B2 ) de frein s'effectue à une fréquence supérieure à 10 kHz, notamment supérieure à 1 MHz.

4. Système d'entraînement suivant l'une des revendications précédentes, dans lequel le convertisseur ( 1 ) a un pont ( 8 ) commutable, par lequel la première et la deuxième tensions d'alimentation peuvent être produites à partir d'une tension continue.

5. Système d'entraînement suivant l'une des revendications précédentes, dans lequel le frein ( 14 ) dans/sur le moteur ( 2 ) est raccordé aux lignes ( B1, B2 ) de frein par une diode ( 16 ).

6. Système d'entraînement suivant l'une des revendications précédentes, dans lequel le transmetteur ( 3 ) est raccordé aux lignes ( B1, B2 ) de frein par un redresseur ( 20 ) à pont.

7. Système d'entraînement suivant l'une des revendications précédentes, dans lequel les lignes ( B1, B2 ) de frein sont blindées séparément des lignes ( L1, L2, L3, PE ) de puissance.

8. Système d'entraînement suivant l'une des revendications précédentes,
dans lequel un blindage ( 12 ) global entoure l'ensemble des lignes du dispositif ( 4 ) à lignes.

9. Système d'entraînement suivant l'une des revendications précédentes, dans lequel le moteur ( 2 ) électrique est un moteur triphasé, et le dispositif ( 4 ) à lignes a quatre lignes ( L1, L2, L3, PE ) de puissance.

10. Système d'entraînement suivant l'une des revendications précédentes, dans lequel, pour transmettre des données, tant au convertisseur ( 1 ) qu'au moteur ( 2 ) électrique, un module ( 5, 17 ) d'attaque est couplé aux lignes ( B1, B2 ) de frein.
